# EUROPEAN PATENT SPECIFICATION

(11) **EP 3 526 821 B1**
(45) Date of publication and mention of the grant of the patent: **30.09.2020**
(21) Application number: 17816449.7
(22) Date of filing: 06.11.2017
(51) Int. Cl.: H01L 33/62, H01L 33/64

(54) **METHOD OF MANUFACTURING AN LED LIGHTING DEVICE COMPRISING A LEAD FRAME**
VERFAHREN ZUR HERSTELLUNG EINER LED-BELEUCHTUNGSVORRICHTUNG MIT EINEM LEITERRAHMEN
PROCÉDÉ DE FABRICATION D'UN DISPOSITIF D'ÉCLAIRAGE COMPRENANT UNE GRILLE DE CONNEXION

(30) Priority: 11.11.2016 WO PCT/CN2016/105450; 12.12.2016 EP 16203504
(43) Date of publication of application: 21.08.2019
(73) Proprietor: Lumileds Holding B.V., 1118 CL Schiphol (NL)
(72) Inventor: XIE, Yuan, 52068 Aachen (DE); MERTENS, Juergen, 52068 Aachen (DE); LEE, Sze, Kuang, 52068 Aachen (DE); CHEN, Nan, 52068 Aachen (DE)
(74) Representative: ter Heegde, Paul Gerard Michel
(86) International application number: PCT/EP2017/078293
(87) International publication number: WO 2018/087027

(56) References cited:
- JP-A- 2007 012 657
- US-A- 3 650 232
- US-A- 4 797 726
- US-A- 5 291 059
- US-A1- 2004 022 016

## Description

### FIELD OF THE INVENTION

The invention describes a method of manufacturing ; an LED lighting device comprising a lead frame.

### BACKGROUND OF THE INVENTION

In the manufacture of light-emitting diode (LED) lighting devices, one approach is to mount an LED die or wafer-level package onto a lead frame or metal carrier. The lead frame comprises contact regions that make electrical contact with the anode and cathode of an LED die, and a voltage source can be connected across the LED by means of the electrode contact regions. The lead frame also acts as a primary heat spreader, since it is directly connected to the LED package. Advances in LED chip technology have led to very small die size with favourably high light output. The small die size requires a small gap between the anode and cathode contact regions of the lead frame or carrier. During operation of an LED, the anode and cathode become hot so that any contact areas to which the die is mounted are subject to thermal deformation. US 4,797,726 describes a method of protecting a semiconductor chip from such thermal stress. US 2004/022016 A1 discloses a method of forming a first and a second mounting surface from a material. The first mounting surface is connected to, but spaced from, the second mounting surface by a mounting surface distance. The method further comprises reducing the mounting surface distance. JP 2007 12657 A discloses a method of manufacturing a semiconductor device comprising: a lead structure including a die pad and a suspension lead. The suspension lead is plastic deformed in order to displace the suspension lead with respect to the die pad and determine the gap between the suspension lead and the die pad.

A lead frame is effectively a frame that holds a plurality of leads in place. The leads are the contact regions to which electrical components will later be soldered. The "frame" itself may be entirely or partially discarded by cutting away any unnecessary areas after the electrical components have been mounted to the leads. A lead frame is generally stamped or punched from a piece of sheet metal or a sheet metal strip, using a stamping press with an appropriately shaped stamping tool and corresponding die. It is a challenge to manufacture lead frames for very small LED die packages, since the gap between anode and cathode may comprise only a fraction of a millimetre. For example, LED die packages with an anode-cathode clearance of only 150 µm - 250 µm are currently being manufactured, and this clearance may be expected to decrease further as the technology advances. However, there is a limit to the smallest clearance that can be achieved by a conventional stamping tool, particularly since the lead frame can have a thickness in millimetre range in order to be able to effectively transport the heat dissipated by an LED. For example, a practicable sheet metal thickness may lie in the range 0.5 - 3.0 mm in order for the stamped lead frame to function satisfactorily as a heat spreader. Generally, a conventional stamping tool is designed to stamp through sheet metal so that the space between adjacent regions is no less than the thickness of the sheet metal. In other words, the ratio of sheet thickness to the smallest achievable gap is 1:1, so that the gap width achievable by a conventional stamping press is too wide for the LED die packages mentioned above. This constraint arises from the need to ensure that the stamping procedure can be performed without interruption for an essentially unlimited number of times.

This problem can be addressed by developing a stamping press that can achieve the desired narrow clearance between electrode contact regions. However, redesign of a stamping press is associated with significant expense, particular since the gap between electrode contact regions must be very precise and uniform. Special tooling modifications to achieve small gap widths are therefore generally limited to the production of lead frame prototypes. Another way of dealing with the problem may be to stamp a lead frame with a large region that will later be sub-divided by cutting or milling into two, four or more individual electrode contact regions. A cutting or milling step can use finer tools that are capable of cutting or forming the desired narrow slit or gap over which the small LED dies can later be mounted. However, owing to the level of precision required in forming the gap or slit between contact regions, such additional tools and the additional tooling step add significantly to the overall cost of the LED devices.

Therefore, it is an object of the invention to provide a more economical way of manufacturing an LED lighting device comprising a lead frame.

### SUMMARY OF THE INVENTION

The object of the invention is achieved by the method of claim 1 of manufacturing an LED lighting device comprising a lead frame.

According to the invention, the lead frame manufacturing method comprises the steps of preparing a stamping tool to stamp a lead frame from sheet metal, so that the lead frame includes a plurality of LED electrode contact regions or tiles, wherein complementary anode/cathode contact regions are separated by an initial gap width; and also a number of narrow connecting bars, bridges or fillets, wherein a connecting bar extends between two regions of the lead frame. The method further comprises a step of using the stamping tool to stamp the lead frame; and subsequently deforming at least one connecting bar of the stamped lead frame to reduce the gap width between complementary contact regions to a final gap width, and mounting at least one semiconductor device onto the complementary electrode contact regions of the lead frame. Furthermore, in the method according to the invention, the at least one semiconductor device is a light emitting diode (LED) die package, and the step of deforming a connecting bar comprises bending a portion of a connecting bar out of the plane (P) of the lead frame to shorten the length of the connecting bar.

Of course, the tool preparation step needs only be carried out once. After preparing the tool of a conventional stamping press to stamp the desired lead frame shape, the tool can be used repeatedly to stamp lead frames from sheet metal, for example from a continuous band of sheet metal fed from a roll into the stamping press at an appropriate rate. Such a stamping press can be prepared to stamp or punch one or more lead frames from a sheet. Equally, a stamping press can stamp a series of lead frames in a continuous strip of sheet metal.

During stamping, portions of the sheet metal are punched out, leaving a desired arrangement of interconnected regions, most of which serve a specific purpose in the end device. Specifically, the stamped lead frame will comprise several electrode contact regions or "tiles" and any number of connecting bars. Initially, the electrode contact regions are separated by gap widths that are easily achievable by the conventional stamping press. As indicated above, such gap widths are too large for use with very small LED die packages that require a clearance of only a few hundred µm or less. The deformation step of the inventive method is carried out on the stamped lead frame to deform at least one connecting bar of the stamped lead frame, with the result that the gap width between complementary contact regions or tiles is reduced to the desired clearance width. An advantage of the inventive method is that a final gap width or clearance of only 250 µm or less can easily be achieved, even if the initial stamped gap width was the same as the sheet metal thickness, even for relatively thick sheet metal. Another advantage of the inventive method is that the lead frame can be produced with relatively little effort and at low cost.

According to the invention, the lead frame achieved by the inventive manufacturing method comprises a plurality of LED electrode contact regions, wherein complementary contact regions are separated by a gap width of at most 250 µm after the deformation step. The inventive lead frame is cheap to manufacture and can be used as a carrier for very small LED die packages.

An LED lighting device comprising a lead frame manufactured by a method according to the invention therefore comprises one or more LED die packages mounted onto complementary anode and cathode contact regions of the lead frame, and the LED die packages can have an electrode clearance of only 250 µm or less. The LED lighting device which can be achieved using the inventive lead frame can therefore be favourably economical to manufacture, since there is no need for expensive tooling solutions in the preparation of the lead frames for the required narrow electrode clearance.

The dependent claims and the following description disclose particularly advantageous embodiments and features of the invention. Features of the embodiments may be combined as appropriate.

A stamped lead frame generally includes various areas that will later be discarded. The reason for this is to simplify the stamping process and also - more importantly - to simplify the component mounting process. For example, LED die packages can be mounted to the electrode regions of a continuous series of lead frames in a soldering step. In this way, hundreds of devices can be prepared in an efficient and cost-effective manner. After a soldering step, the individual devices can be cut from the lead frame strip or sheet. For this reason, the stamping tool is generally prepared to include such "superfluous" or "waste" regions in the stamped lead frame, and the useful regions (such as the electrode contact regions) are initially held in place by connecting bars, which may also be later cut from the lead frame and discarded or recycled. The connecting bars may form an outer frame around the tiles, or can extend between an outer frame and the tiles.

In the inventive method, the electrode contact regions or tiles are initially stamped so that they are separated by a relatively large gap, and are held in place within the frame by the connecting bars. In one preferred embodiment of the invention, the stamping tool is prepared to stamp one or more connecting bars extending from a tile to a side bar of the lead frame. Preferably, such a connecting bar extends diagonally from a tile to a side bar of the lead frame. A connecting bar is preferably narrow so that it can be deformed with relatively little effort. To this end, the stamping tool is preferably prepared to stamp a connecting bar that has a width corresponding essentially to the thickness of the sheet metal. A connecting bar width in the millimetre range is easily achievable by most conventional stamping press arrangements that handle that thickness of sheet metal.

In a reference embodiment, not being part of the invention, the step of deforming a connecting bar comprises bending or displacing the connecting bar within the plane of the lead frame, which has the effect of adjusting the angle of the connecting bar. In this way, the tile at the end of this connecting bar will be displaced towards the other tile(s), thereby effectively reducing the gap or clearance between those tiles.

In accordance with the invention, the step of deforming a connecting bar comprises forcing a short length of the connecting bar out of the plane of the lead frame. This results in a small "arch" formed from a section of that connecting bar. The deformation only involves a geometrical alteration but does not involve stretching, so that an arch, extending out of the plane of the lead frame, effectively shortens the length of the connecting bar. In this way, any electrode contact regions linked by this connecting bar will be displaced towards each other, effectively reducing the gap or clearance between them.

The inventive method provides a simple and straightforward way of achieving a very narrow clearance between electrode contact regions. However, care must be taken to ensure that a gap between electrode contact regions is uniform over its entire length. Furthermore, the final gap width or clearance to be achieved also depends on the basis of thermal requirements of the type of LED die to be mounted over complementary contact regions of the lead frame. The final gap width should therefore not be excessively narrow. A minimum gap width of about 50 µm may be sufficient to avoid solder from "bridging" the gap and causing a short circuit. To this end, in a preferred embodiment of the invention, the method includes a step of inserting a gauge in the space between complementary contact regions to limit the extent of deformation of a connecting bar. The gauge preferably has the same width as the desired clearance, and can be realised as a shim or similar device. The gauge can be held in place while the deformation step is being carried out. These techniques ensure that the gap is narrow and that the vertical faces of the opposing tiles are parallel over the entire length of the gap.

The deformation step is performed after stamping and prior to soldering. Between these stages, the tiles should preferably not depart from their new positions. Therefore, in a further preferred embodiment of the invention, the deformation step is followed by a stabilizing step in which the stresses arising during the deformation step are reduced and/or in which the positions of the electrode contact regions are spatially fixed. For example, an annealing procedure can be carried out, in which the lead frame is heated and cooled. Annealing can be carried out during the deformation step and/or after the deformation step. Alternatively or in addition, a vertical deformation of the connecting bars (out of the plane of the lead frame) can follow their horizontal deformation (within the plane of the lead frame) to fix the positions of the electrode contact regions. Another way of fixing the electrode contact regions in place might be by applying an over-moulding technique in which, after the deformation step, the lead frame is aligned in a moulding tool and spatially fixed by plastic over-moulding. For example, plastic over-moulding applied on either side of the lead frame can hold the electrode contact regions in place. A moulding tool is preferably shaped to hold at least the tiles in place while applying the over-mould plastic material. The plastic material should be electrically isolating and should have favourable thermal characteristics since a soldering step will follow. Stabilizing the electrode contact regions by one or more of the above steps will reduce stresses in the connecting bars or bridges and ensure that the lead regions are spatially fixed in place and will not change position.

In a later manufacturing step, one or more LED dies - for example surface mount LED dies - can be attached in a reflow soldering process across the narrow slit between the electrode contact regions. This step can be followed by cutting away any waste or superfluous material from the lead frame to remove short circuit connections. The device can then be packaged as required.

Other objects and features of the present invention will become apparent from the following detailed descriptions considered in conjunction with the accompanying drawings. It is to be understood, however, that the drawings are designed solely for the purposes of illustration and not as a definition of the limits of the invention.

### BRIEF DESCRIPTION OF THE DRAWINGS

- Fig 1: shows a first embodiment of a stamped lead frame obtained by the inventive method;
- Fig. 2: shows the lead frame of Fig. 1 after a specific deformation step, this specific deformation step not being part of the invention;
- Fig. 3: shows a second embodiment of a stamped lead frame obtained by the inventive method;
- Fig. 4: shows the lead frame of Fig. 3 after a deformation step according to the invention;
- Fig. 5: shows a perspective view of the lead frame of Figs. 3 and 4;
- Fig. 6: shows a simplified schematic of a stamping press as used by the inventive method;
- Fig. 7: illustrates stages of the inventive method;
- Fig. 8: shows part of an LED light-emitting arrangement comprising a lead frame obtained by the inventive method;
- Fig. 9: shows a third embodiment of a stamped lead frame obtained by the inventive method;
- Figs. 10 and 11: show the lead frame of Fig. 9 in further manufacturing stages;
- Fig. 12: shows an embodiment of the inventive LED lighting device.

In the drawings, like numbers refer to like objects throughout. Objects in the diagrams are not necessarily drawn to scale.

### DETAILED DESCRIPTION OF THE EMBODIMENTS

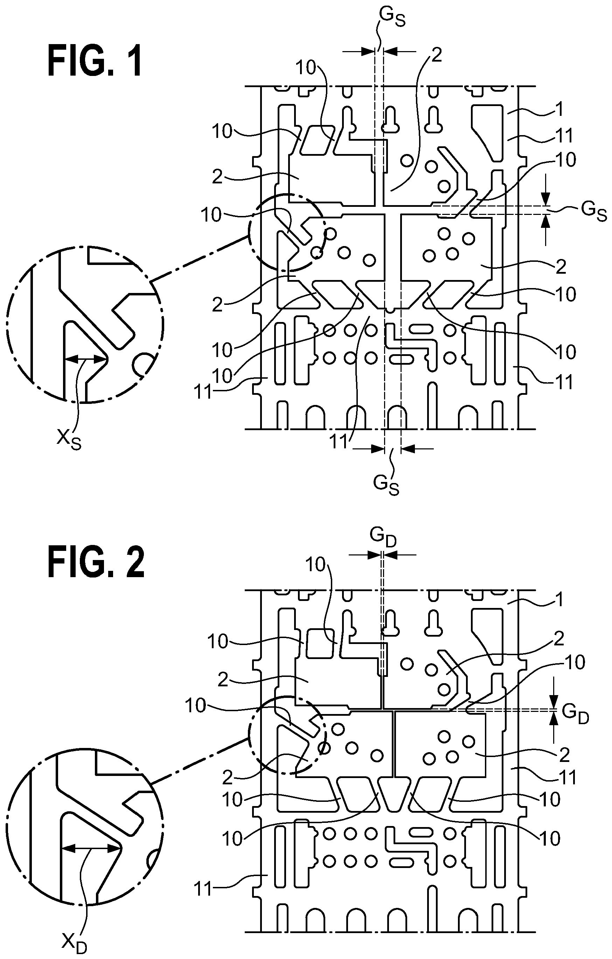

Fig 1 shows a first embodiment of a lead frame 1, obtained by stamping or punching using a tool that has been prepared to stamp the lead frame shape shown in the diagram. The tool can be used to repeatedly stamp lead frames from a strip of sheet metal that is fed through the tool. During stamping, portions of the sheet metal strip are punched out, leaving a desired arrangement of regions, each of which generally serves a specific purpose later on. In the diagram, the lead frame 1 is a portion of a longer strip of stamped lead frames, and shows a relevant portion with four tiles 2 or LED electrode contact regions 2, to which the electrodes of one or more LED die packages will later be soldered. For efficient heat transport from the LEDs during operation, the lead frame 1 generally requires a thickness in the range of about 3.0 mm. As mentioned above, the smallest achievable gap size between portions of a stamped lead frame is limited by the constraints of conventional or standard stamping tools. The gap width Gs between tiles 2 of the stamped lead frame 1 is therefore unfavourably wide. To overcome this constraint, the stamping tool is prepared using the inventive method so that connecting bars 10 are provided between the tiles 2 and the rest of the lead frame 1. The diagram shows four tiles 2, three of which are connected by such connecting bars 10 to the rest of the lead frame 1. These connecting bars 2 are thin and relatively long, so that they can be bent within the plane of the lead frame 1 (i.e. within the plane of the page) with little effort. A connecting bar 10 can be regarded as the hypotenuse of a right triangle, as indicated in the enlarged view, which shows the connecting bar 10 on the left-hand side of the bottom-left tile 2 initially subtending an angle to the side bar of the lead frame 1 so that the longer "virtual" leg has a length X_{S}. Bending this connecting bar 10 sideways within the plane of the lead frame 1, outside the scope of the present invention, will shorten one leg and lengthen the "virtual" leg, while the length of the hypotenuse (the connecting bar 10) remains fixed.

The result of such a deformation step is shown in Fig. 2. The initial "virtual leg" length X_{S} after stamping has been increased to a longer length X_{D} by deformation. This brings the tile 2 at the end of that connecting bar 10 closer to its neighbouring tiles 2. In Fig. 2, all the tiles 2 connected by connecting bars 10 to the rest of the lead frame 1 have been moved by deforming the connecting bars 10. The short arrows in the diagram indicate the direction of deformation of the connecting bars 10. The top-right tile 2 in the diagram does not require any connecting bars, since it is sufficient to move or displace the other three tiles 2 in the direction of the top-right tile 2. The result of displacing the tiles 2 in this manner, within the plane of the lead frame 1, is to decrease the gap width between tiles 2. After deformation, the gap width G_{D} is significantly smaller than the initial gap width Gs. The inventive method can achieve a gap width G_{D} as small as 150 µm, even for a lead frame thickness in the range of 3.0 mm. This opens up the possibility of placing very small surface-mount LED packages across complementary tiles 2 of the lead frame 1, while being able to manufacture the lead frame 1 very economically using a standard stamping tool.

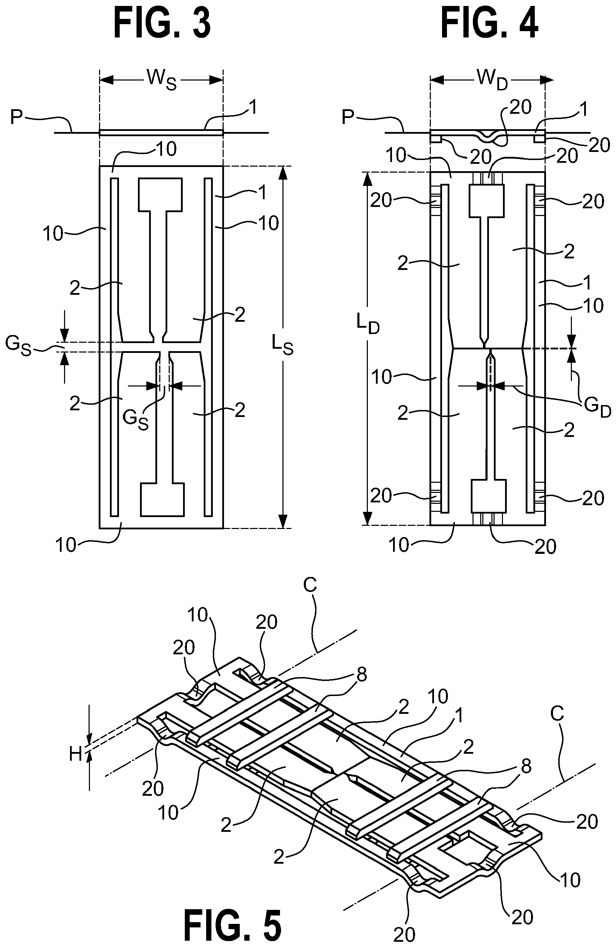

Fig. 3 shows an alternative embodiment of a lead frame 1 stamped from a sheet metal strip. The diagram shows a plan view of the lead frame 1, and an end-face view (in the top part of the diagram). Initially, the stamped lead frame 1 has a width Ws and a length L_{S}, and has been stamped to form four elongated tiles 2 and connecting bars 10 extending between the four corners of the rectangular lead frame 1. The tiles 2 will receive the anodes and cathodes of LED packages later on. Like the embodiment described in Figs. 1 and 2 above, no particular effort need be taken to stamp the lead frame 1 with a small gap width between complementary tiles 2. Initially, the stamped lead frame 1 has an initial gap width Gs between complementary tiles 2. The stamped lead frame 1 is then subject to a deformation step. In this embodiment, as shown in Fig. 4, the thin straight sections 10 or connecting bars 10 of the lead frame 1 are according to the invention bent out of the plane of the lead frame 1. Each bent section appears as an inverted "arch", as shown in the end-face view (in the top part of the diagram). The plan view in Fig. 4 shows three such sections at the upper region of the lead frame 1, and three such sections in the lower region. A suitable tool can be used to from all six "arches" simultaneously, for example. The result of the deformation step is to shorten the overall width W_{D} and length L_{D} of the lead frame 1, effectively moving the four tiles 2 closer together, so that the resulting gap width G_{D} is shortened correspondingly. The amount by which the gap width is shortened can be determined by using a suitable tool to form suitably dimensioned "arches". Fig. 5 shows a perspective view of the lead frame 1 described in Figs. 3 and 4, and clearly indicates the six inverted "arches" formed to achieve the favourably small gap width G_{D}. The diagram also shows over-mould plastic elements 8 attached from above and below the lead frame to the tiles 2 and lead frame side bars in order to hold these together after the lead frame 1 is cut to remove short-circuit connections between the tiles 2. Exemplary cutting lines C are indicated in the diagram. Superfluous material at the outer ends of the lead frame 1 is removed and can be re-cycled.

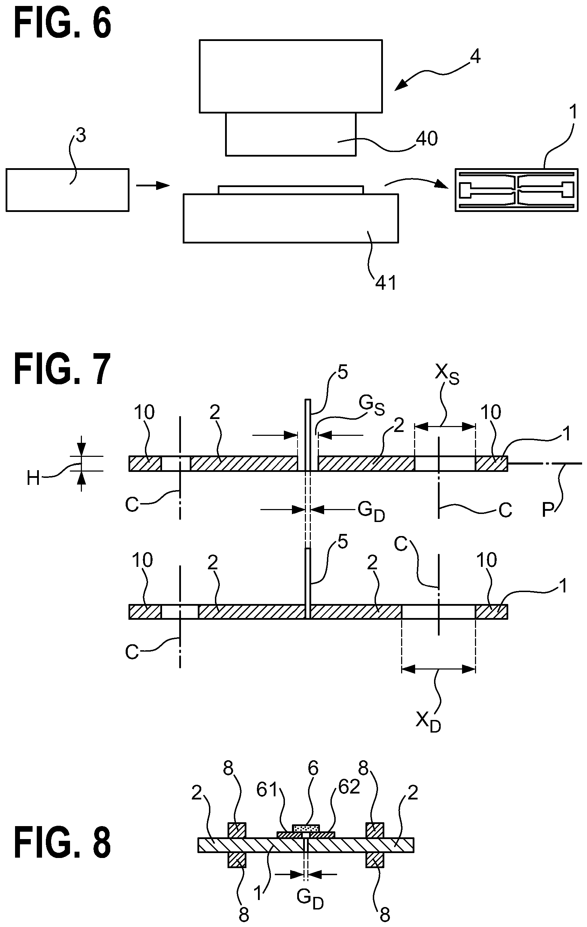

Fig. 6 shows a simplified schematic of a stamping press 4, with a stamping tool 40 prepared to stamp a lead frame as described in Fig. 3. A piece of sheet metal 3 is inserted between the stamping tool 40 and a stamping die 41, and the stamping press 4 is actuated to perform a punching or stamping action. The resulting stamped lead frame 1 is then removed from the press 4. Of course, a continuous strip of sheet metal 3 can be fed into the press, and the resulting lead frame can also be in the form of a continuous strip, as will be known to the skilled person. A separate tool can be used to perform the deformation step, and this can be carried out at the same location, or at a different location as appropriate.

Fig. 7 illustrates a deformation step, and shows a gauge 5 inserted between complementary tiles 2 of a stamped lead frame 1 with thickness H. The gauge 5 can have a width G_{D} in the range of 100 - 250 µm, corresponding to the desired gap width G_{D} between electrode contact regions of an LED die package. The width Gs of the gap is initially quite wide, for example the ratio Gs:H can be 1:1 to allow for a low-cost stamping procedure. During the deformation step, for example by bending the connecting bars 10 of Figs. 1 and 2 within the plane P of the lead frame 1, the gap is reduced to the width G_{D} of the gauge 5. Deformation can involve bending the connecting bars 10 of Figs. 1 and 2 within the plane P of the lead frame 1. When a connecting bar 10 is regarded as the hypotenuse of a right triangle as explained in Figs. 1 and 2 above, the initial "virtual leg" length Xs after stamping is increased to a longer length X_{D} by deformation. This brings the tile 2 at the end of a connecting bar 10 closer to its neighbouring tile(s), as illustrated in the lower part of the diagram.

Although not shown in this diagram, the deformation step can involve forming "arches" as illustrated in Figs. 3 - 5 out of the plane P of the lead frame 1. In either case, the initially wide gap is reduced to a favourably narrow gap with the same width G_{D} as the gauge 5. Using the gauge 5 to control the gap width can ensure that the gap width is not too narrow. The diagram also indicates cutting lines C, indicating the portions of lead frame 1 that will be discarded, for example after over-moulding and soldering.

Fig. 8 shows part of an LED light-emitting arrangement. Here, the anode 61 and cathode 62 of an SMD LED die package 6 are soldered onto complementary tiles 2 of the inventive lead frame 1. The favourably narrow gap width G_{D} between the complementary tiles 2 allows the use of a favourably small SMD LED die package 6. The diagram also shows over-moulded plastic elements 8 that act to hold the tiles 2 in place.

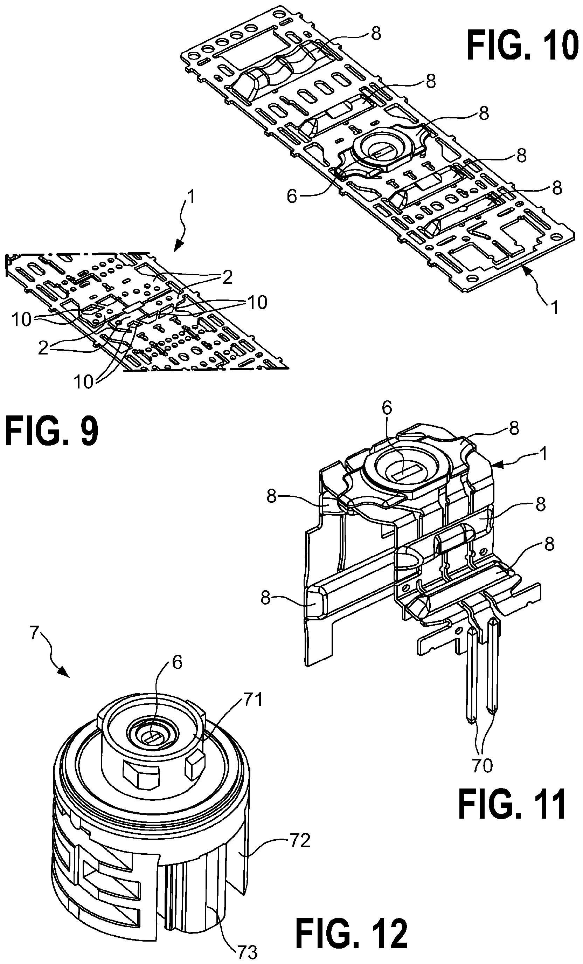

Fig. 9 shows a further embodiment of a lead frame 1, obtained in a similar manner to the lead frame of Fig. 1. The diagrams shows a lead frame with four tiles 2 or LED electrode contact regions 2, to which the electrodes of three LED die packages will later be soldered. The stamping tool used to form the lead frame 1 has left connecting bars 10 between three of the tiles 2 and the rest of the lead frame 1. These connecting bars 10 can be bent within the plane of the lead frame 1 (i.e. within the plane of the page) with little effort. This allows a very narrow gap width between tiles 2, as narrow as 150 µm, even for a lead frame thickness in the range of 3.0 mm. After the lead frame has been prepared in this way, a surface-mount LED package 6 can be mounted across complementary tiles 2 of the lead frame 1.

Fig. 10 indicates over-mould elements 8 arranged to hold various parts of the lead frame together, to provide a window for the LEDs 6, to cover other electronic components mounted on the lead frame 1, and also to act as spacers when the lead frame 1 is incorporated in a lighting device.

Fig. 11 shows a further stage in the manufacture of a lighting device. Here, the lead frame 1 has been cut or trimmed to remove superfluous material, and the remainder has been bent at certain pre-determined locations to achieve a specific shape. Connectors 70 have been welded to positive and negative tabs of the lead frame 1. A final over-moulding step can then be carried out if required. Fig. 12 shows a final stage in the manufacture of the LED lighting device 7, with the lead frame embedded in a unit that comprises both a housing 71 and a heat-sink 72. The housing and/or the heat sink can be made of thermally conductive plastics .The connectors are enclosed in a socket portion 73 which can mate with a corresponding plug connector.

The embodiment of the LED lighting device 7 shown in Fig. 12 can be particularly suitable for an automotive LED front lighting application, and can be developed especially for the original equipment manufacturer (OEM) market. The inventive concept provides a compact LED light source enclosed in a lamp unit that can act in a manner similar to conventional lamps for such front lighting applications, so that the lighting device 7 can be easily installed. This embodiment of an LED lighting device does not require an active cooling system or driver box is needed. Due to the precise placement of the LEDs and the over-moulded plastic protection, the inventive lighting device exhibits a long lifetime and a favourable high degree of mechanical strength.

Although the present invention has been disclosed in the form of preferred embodiments and variations thereon, it will be understood that numerous additional modifications and variations could be made thereto without departing from the scope of the invention. For example, the inventive method can be used to provide a lead frame for carrying any electrical device that requires a very narrow clearance between leads.

For the sake of clarity, it is to be understood that the use of "a" or "an" throughout this application does not exclude a plurality, and "comprising" does not exclude other steps or elements.

## Claims

1. A method of manufacturing an LED lighting device (7) comprising a lead frame (1), comprising the steps of
A) preparing a stamping arrangement (4) to stamp a lead frame (1) comprising
- a plurality of electrode contact regions (2), wherein complementary contact regions (2) comprise an anode contact region and a cathode contact region separated by an initial gap width (Gs); and
- a number of connecting bars (10), wherein a connecting bar (10) extends between regions of the lead frame (1);
B) using the stamping arrangement (4) to stamp the lead frame (1); and
C) deforming at least one connecting bar (10) of the stamped lead frame (1) to reduce the gap width between complementary contact regions (2) to a final gap width (G_{D}), and
D) mounting at least one semiconductor device onto the complementary electrode contact regions (2) of the lead frame (1),
and wherein,
the at least one semiconductor device is a light emitting diode (LED) die package (6), and
the step of deforming a connecting bar (10) comprises bending a portion of a connecting bar (10) out of the plane (P) of the lead frame (1) to shorten the length of the connecting bar (10).

2. A method according to claim 1, wherein the stamping arrangement (4) is prepared to stamp one or more connecting bars (10) extending from an electrode contact region (2) to a side bar (11) of the lead frame (1).

3. A method according to claim 1 or claim 2, wherein a connecting bar (10) extends diagonally from an electrode contact region (2) to a side bar (11) of the lead frame (1).

4. A method according to any of the preceding claims, wherein the step of deforming a connecting bar (10) further comprises bending a connecting bar (10) within the plane (P) of the lead frame.

5. A method according to any of the preceding claims, wherein stamping arrangement (4) is prepared to stamp at least one connecting bar (10) with a width corresponding to the thickness (H) of the lead frame (1).

6. A method according to any of the preceding claims, comprising the step of inserting a gauge (5) in the gap between complementary contact regions (2) to limit the extent of deformation of a connecting bar (10).

7. A method according to any of the preceding claims, wherein the deformation step is followed by an annealing step to fix the final positions of the contact regions (2).

8. A method according to any of the preceding claims, wherein the deformation step is followed by an over-moulding step to fix the final positions of the contact regions (2).

9. A method according to any of the preceding claims, wherein the stamping tool is prepared to achieve an initial gap width (Gs) that corresponds to the thickness (H) of the stamped lead frame (1).

## Patentansprüche

1. Verfahren zur Herstellung einer LED-Beleuchtungsvorrichtung (7) mit einem Leiterrahmen (1), umfassend die folgenden Schritte:
A) Präparieren einer Stanzanordnung (4) zum Stanzen eines Leiterrahmens (1), der umfasst:
- eine Mehrzahl von Elektrodenkontaktregionen (2), wobei komplementäre Kontaktregionen (2) eine Anodenkontaktregion und eine Kathodenkontaktregion umfassen, die durch eine anfängliche Spaltbreite (Gs) getrennt sind; und
- eine Anzahl von Verbindungsstangen (10), wobei sich eine Verbindungsstange (10) zwischen Regionen des Leiterrahmens (1) erstreckt;
B) Verwenden des Stanzanordnung (4) zum Stanzen des Leiterrahmens (1); und
C) Verformen mindestens einer Verbindungsstange (10) des gestanzten Leiterrahmens (1), um eine Spaltbreite zwischen komplementären Kontaktregionen (2) auf eine endgültige Breite (GD) zu verringern, und
D) Montieren mindestens eines Halbleiterbauelements auf den komplementären Elektrodenkontaktregionen (2) des Leiterrahmens (1),
und wobei
das mindestens eine Halbleiterbauelement ein Gehäuse (6) eines Leuchtdioden-(LED-)Dies ist; und
der Schritt des Verformens einer Verbindungsstange (10) ein Biegen eines Abschnitts einer Verbindungsstange (10) aus der Ebene (P) des Leiterrahmens (1) zum Verkürzen der Länge der Verbindungsstange (10) umfasst.

2. Verfahren nach Anspruch 1, wobei die Stanzanordnung (4) zum Stanzen einer oder mehrerer Verbindungsstangen (10) präpariert wird, die sich von einer Elektrodenkontaktregion (2) zu einer Seitenstange (11) des Leiterrahmens (1) erstrecken.

3. Verfahren nach Anspruch 1 oder Anspruch 2, wobei eine Verbindungsstange (10) sich von einer Elektrodenkontaktregion (2) diagonal zu einer Seitenstange (11) des Leiterrahmens (1) erstreckt.

4. Verfahren nach einem der vorhergehenden Ansprüche, wobei der Schritt des Verformens einer Verbindungsstange (10) ferner ein Biegen einer Verbindungsstange (10) innerhalb der Ebene (P) des Leiterrahmens umfasst.

5. Verfahren nach einem der vorhergehenden Ansprüche, wobei die Stanzanordnung (4) zum Stanzen mindestens einer Verbindungsstange (10) mit einer Breite präpariert wird, die der Dicke (H) des Leiterrahmens (1) entspricht.

6. Verfahren nach einem der vorhergehenden Ansprüche, ferner umfassend den Schritt des Einführens einer Lehre (5) in den Spalt zwischen komplementären Kontaktregionen (2), um das Ausmaß von Verformung einer Verbindungsstange (10) zu begrenzen.

7. Verfahren nach einem der vorhergehenden Ansprüche, wobei auf den Verformungsschritt ein Ausheilschritt zum Fixieren der endgültigen Positionen der Kontaktregionen (2) folgt.

8. Verfahren nach einem der vorhergehenden Ansprüche, wobei auf den Verformungsschritt ein Überspritzschritt zum Fixieren der endgültigen Positionen der Kontaktregionen (2) folgt.

9. Verfahren nach einem der vorhergehenden Ansprüche, wobei das Stanzwerkzeug zum Erreichen einer anfänglichen Spaltbreite (Gs) präpariert wird, die der Dicke (H) des gestanzten Leiterrahmens (1) entspricht.

## Revendications

1. Procédé de fabrication d'un dispositif d'éclairage à DEL (7) comprenant une grille de connexion (1) comprenant les étapes de
A) préparation d'un agencement d'estampage (4) pour estamper une grille de connexion (1) comprenant
- une pluralité de régions de contact d'électrode (2), dans lequel des régions de contact (2) complémentaires comprennent une région de contact d'anode et une région de contact de cathode séparées par une largeur d'espace initial (Gs) ; et
- un certain nombre de barres de liaison (10), dans lequel une barre de liaison (10) s'étend entre des régions de la grille de connexion (1) ;
B) utilisation de l'agencement d'estampage (4) pour estamper la grille de connexion (1) ; et
C) déformation d'au moins une barre de liaison (10) de la grille de connexion (1) estampée pour réduire la largeur d'espace entre des régions de contact (2) complémentaires jusqu'à une largeur d'espace final (G_{D}), et
D) montage d'au moins un dispositif à semi-conducteur sur les régions de contact d'électrode (2) complémentaires de la grille de connexion (1),
et dans lequel,
l'au moins un dispositif à semi-conducteur est un boîtier de puce de diode électroluminescente (DEL) (6), et
l'étape de déformation d'une barre de liaison (10) comprend la flexion d'une partie de la barre de liaison (10) en dehors du plan (P) de la grille de connexion (1) pour raccourcir la longueur de la barre de liaison (10).

2. Procédé selon la revendication 1, dans lequel l'agencement d'estampage (4) est préparé pour estamper une ou plusieurs barres de liaison (10) s'étendant d'une région de contact d'électrode (2) à une barre latérale (11) de la grille de connexion (1).

3. Procédé selon la revendication 1 ou la revendication 2, dans lequel une barre de liaison (10) s'étend diagonalement d'une région de contact d'électrode (2) à une barre latérale (11) de la grille de connexion (1).

4. Procédé selon l'une quelconque des revendications précédentes, dans lequel l'étape de déformation d'une barre de liaison (10) comprend en outre la flexion d'une barre de liaison (10) à l'intérieur du plan (P) de la grille de connexion.

5. Procédé selon l'une quelconque des revendications précédentes, dans lequel l'agencement d'estampage (4) est préparé pour estamper au moins une barre de liaison (10) avec une largeur correspondant à l'épaisseur (H) de la grille de connexion (1).

6. Procédé selon l'une quelconque des revendications précédentes, comprenant l'étape d'insertion d'une jauge (5) dans l'espace entre les régions de contact (2) complémentaires pour limiter l'étendue de la déformation d'une barre de liaison (10).

7. Procédé selon l'une quelconque des revendications précédentes, dans lequel l'étape de déformation est suivie par une étape de recuit pour fixer les positions finales des régions de contact (2).

8. Procédé selon l'une quelconque des revendications précédentes, dans lequel l'étape de déformation est suivie par une étape de surmoulage pour fixer les positions finales des régions de contact (2).

9. Procédé selon l'une quelconque des revendications précédentes, dans lequel l'outil d'estampage est préparé pour obtenir une largeur d'espace initial (Gs) qui correspond à l'épaisseur (H) de la grille de connexion (1) estampée.
